# EUROPEAN PATENT APPLICATION

(11) **EP 4 821 750 A1**
(43) Date of publication of application: **14.10.2026**
(21) Application number: 24900984.6
(22) Date of filing: 29.11.2024
(51) Int. Cl.: B60L 53/60, G01R 31/52, G01R 31/66, G01R 15/04, G01R 31/00

(54) **ELECTRIC VEHICLE CHARGING CONTROLLER AND CHARGING CONTROL METHOD THEREOF**

(30) Priority: 05.12.2023 KR 20230174474
(71) Applicant: LG Innotek Co., Ltd., Seoul 07796 (KR)
(72) Inventor: SHIN, Kwang Seob, Seoul 07796 (KR); KIM, Hyun Woong, Seoul 07796 (KR); SONG, Il Jong, Seoul 07796 (KR)
(74) Representative: Plasseraud IP
(86) International application number: PCT/KR2024/019336
(87) International publication number: WO 2025/121798

(57) **Abstract**

An electric vehicle charging controller (EVCC) according to an embodiment of the present invention includes a connection check 1 (CC1) line configured to transmit a signal to detect a connector connection between an electric vehicle supply equipment (EVSE) and the electric vehicle charging controller, a connection check 2 (CC2) line configured to transmit a signal to detect the connector connection between the EVSE and the electric vehicle charging controller, a first voltage detection unit connected to the CC1 line to detect the voltage of the CC1 line, a second voltage detection unit connected to the CC2 line to detect the voltage of the CC2 line, and a control unit configured to determine whether a protective earth (PE) between the EVSE and the electric vehicle charging controller is open based on the detected values by the first and second voltage detection units being within a predetermined range, wherein the second voltage detection unit includes a back-to-back field effect transistor (FET) connected to the CC2 line, a positive voltage monitoring circuit, and a negative voltage monitoring circuit.

## Description

### [Technical Field]

The present invention relates to electric vehicles, and more particularly, to an electric vehicle charging controller and a charging control method thereof.

### [Background Art]

Eco-friendly vehicles, such as Electric Vehicles (EVs) or Plug-In Hybrid Electric Vehicles (PHEVs), rely on electric vehicle supply equipment (EVSE) installed at charging stations to replenish their battery power.

To charge an electric vehicle, the EV and EVSE communicate through a charging connector that connects the EV to the EVSE. Once the charging connector is connected between the EVSE and the EV, a signaling process ensues to initiate the charging operation.

A high-voltage current flows between the EVSE and the EV, and in the event of an emergency shutdown, the EV can transmit a stopping message specifying the reason for shutdown to the EVSE.

When the PE line, serving as the grounding wire between the EVSE and EV, is open, an emergency shutdown is necessary for safety reasons. Consequently, a technology is required to detect PE open rapidly and accurately.

### [Disclosure]

### [Technical Problem]

It is an object of the present invention to provide an electric vehicle charging controller and a charging control method thereof capable of rapidly and accurately detecting a protective earth (PE) open.

### [Technical Solution]

An electric vehicle charging controller (EVCC) according to an embodiment of the present invention includes a connection check 1 (CC1) line configured to transmit a signal to detect a connector connection between an electric vehicle supply equipment (EVSE) and the electric vehicle charging controller, a connection check 2 (CC2) line configured to transmit a signal to detect the connector connection between the EVSE and the electric vehicle charging controller, a first voltage detection unit connected to the CC1 line to detect the voltage of the CC1 line, a second voltage detection unit connected to the CC2 line to detect the voltage of the CC2 line, and a control unit configured to determine whether a protective earth (PE) between the EVSE and the electric vehicle charging controller is open based on the detected values by the first and second voltage detection units being within a predetermined range, wherein the second voltage detection unit includes a back-to-back field effect transistor (FET) connected to the CC2 line, a positive voltage monitoring circuit, and a negative voltage monitoring circuit.

The negative voltage monitoring circuit may include a voltage divider resistor section and an operational amplifier (OP Amp).

The voltage divider resistor section may include a first resistor and a second resistor, one end of the first resistor being connected to the CC2 line, and the other end of the first resistor being connected to one end of the second resistor and the OP Amp.

The first resistor may be 100kΩ or more.

The positive voltage monitoring circuit may include a voltage divider resistor section and an operational amplifier (OP Amp).

The CC1 line may be configured to transmit a signal for detecting the connector connection on the EVSE side, and the CC2 line may be configured to transmit a signal for detecting the connector connection on the electric vehicle charging controller side.

The first voltage detection unit may include a voltage divider resistor section and an operational amplifier (OP Amp).

The control unit may estimate the negative voltage of the voltage value detected by the negative voltage monitoring circuit using a pre-stored voltage matching table.

The electric vehicle charging controller may further include an A+ line configured to transmit a signal to enable the electric vehicle charging controller, an A- line configured to transmit a signal to enable the electric vehicle charging controller, an A+ detection unit configured to detect the voltage of the A+ line, and an A- detection unit configured to detect the voltage of the A- line.

The A+ detection unit and the A- detection unit each may include a voltage divider resistor section and an operational amplifier (OP Amp).

The voltage divider resistor section of the A+ detection unit and the A- detection unit each may include a first resistor and a second resistor, wherein one end of the first resistor may be connected to the A+ line and the A- line, respectively, and the other end of the first resistor may be connected to one end of the second resistor and the OP Amp, and the first resistor may be 100kΩ or more.

A charging control method of an electric vehicle charging controller (EVCC) according to an embodiment of the present invention includes detecting, by a first voltage detection unit, the voltage of a connection check 1 (CC1) line through which a signal for detecting the connector connection between an electric vehicle supply equipment (EVSE) and the electric vehicle charging controller is transmitted, detecting, by a second voltage detection unit, the voltage of a connection check 2 (CC2) line through which a signal for detecting the connector connection between the EVSE and the electric vehicle charging controller is transmitted, and determining that the protective earth (PE) between the EVSE and the electric vehicle charging controller is open based on the values detected by the first and second voltage detection units being within a predetermined range, wherein the second voltage detection unit includes a back-to-back field effect transistor (FET) connected to the CC2 line, a positive voltage monitoring circuit, and a negative voltage monitoring circuit.

### [Advantageous Effects]

The electric vehicle charging controller according to an embodiment of the present invention is advantageous in terms of being capable of rapidly and accurately detecting the PE open between the EVSE and the EV. The electric vehicle charging controller according to an embodiment of the present invention is advantageous in terms of allowing fast and accurate PE open detection in all of the following cases: when no enable signal is received from the EVSE-side auxiliary battery, when an enable signal is received from the EVSE-side auxiliary battery and the ground of the EVSE-side auxiliary battery is connected to the ground of the power source, and when an enable signal is received from the EVSE-side auxiliary battery and the ground of the EVSE-side auxiliary battery is not connected to the ground of the power source.

### [Description of Drawings]

FIGS. 1 to 3 are diagrams illustrating a charging system for an electric vehicle according to an embodiment of the present invention;
FIG. 4 is a diagram illustrating the pinout of the connector included in the EVCC according to an embodiment of the present invention;
FIG. 5 illustrates a fast charging circuit between an EVSE and an EV;
FIG. 6 is an equivalent circuit diagram of a charging interface between an EVSE and an EVCC according to an embodiment of the present invention;
FIG. 7 is an equivalent circuit diagram of the CC2 line between an EVSE and an EVCC according to an embodiment of the present invention;
FIG. 8 is an equivalent circuit diagram of the CC1 line between an EVSE and an EVCC according to an embodiment of the present invention; and
FIG. 9 is an equivalent circuit diagram of the A+ line and A- line between an EVSE and an EVCC according to an embodiment of the present invention.

### [Modes of the Invention]

Hereinafter, preferred embodiments of the present invention are described in detail with reference to the accompanying drawings.

However, the technical concept of the present invention is not limited to the embodiments described herein but can be implemented in various other forms, allowing for selective combination or substitution of one or more components among different embodiments within the scope of the technical concept of the present invention.

Unless explicitly defined otherwise, terms used in the embodiments of the present invention (including technical and scientific terms) should be interpreted in meanings understood by those skilled in the art to which the present invention pertains considering the context of the technology involved, rather than solely based on their usual or dictionary meanings.

Furthermore, the terminology employed in the embodiments of the present invention is intended solely for the purpose of elucidating the embodiments and should not be construed as limiting the scope of the present invention.

In this specification, singular language may include the plural unless specifically mentioned otherwise, and when stated as "at least one (or one or more) of A, B, and (or) C," it may include one or more of all possible combinations of A, B, and C.

Additionally, when describing the components of the embodiments of the present invention, terms such as "first," "second," "A," "B," "(a)," and "(b)" may be used.

These terms are intended solely for the purpose of distinguishing one component from another and do not limit the essence, order, or sequence of respective components.

Furthermore, when a component is described as being "connected," "coupled," or "attached" to another component, it may include not only direct connection, coupling, or attachment but also connection, coupling, or attachment through another component located between the component and the other component.

Additionally, when a component is described as being formed or placed "on or under" another component, "on (above)" or "under (below)" may include not only cases where two components directly contact each other but also cases where one or more other components are formed or positioned between the two components. Additionally, when expressed as "on (above or under (below)," it may include not only the upward direction but also the downward direction relative to a single component.

Hereinafter, a description is made of the charging system for a vehicle with reference to the accompanying drawings where identical or corresponding components are assigned the same reference numbers, and redundant descriptions are omitted.

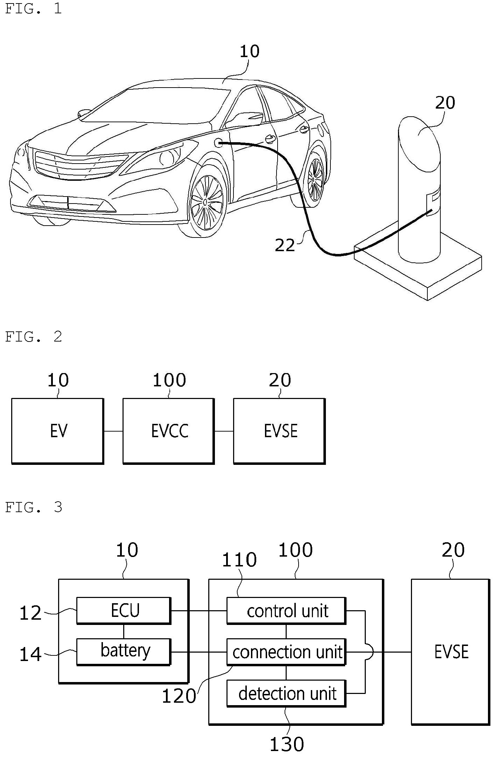

FIGS. 1 to 3 are diagrams illustrating a charging system for an electric vehicle according to an embodiment of the present invention.

With reference to FIGS. 1 to 3, an electric vehicle (EV) 10 may be charged from electric vehicle supply equipment (EVSE) 20. To achieve this, the charging cable 22 connected to the EVSE 20 may be connected to the charging port of the EV 10. Here, EVSE 20 is a facility that supplies AC or DC power, which may be installed at charging stations, within homes, or designed to be portable. EVSE 20 may be interchangeably referred to as a charging station (supply), AC charger (AC supply), DC charger (DC supply), or socket-outlet.

The electric vehicle charging controller (EVCC) 100 is installed within the EV 10 and is connected to the EV 10. For example, the EVCC 100 may be installed inside the trunk of the EV 10, but this is not limiting.

Here, the EVCC 100 may communicate with both the EV 10 and the EVSE 20.

According to an embodiment of the present invention, the EVCC 100 includes a control unit 110, a connection unit 120, and a detection unit 130.

The control unit 110 generates control signals for charging between the EV 10 and EVSE 20. The control signals for charging generated by the control unit 110 may be transmitted to the EVSE 20 via the connection unit 120 or to the electric control unit (ECU) 12 within the EV 10.

The connection unit 120 is connected to the EVSE 20 and transmits signals between the control unit 110 and the EVSE 20. For example, the connection unit 120 may relay charging-related signals received from the EVSE 20 to the control unit 110 and may transmit control signals for charging generated by the control unit 110 to the EVSE 20. The connection unit 120 may also deliver power received from the EVSE 20 to the battery 14 inside the EV 10 according to the charging control signals generated by the control unit 110.

The detection unit 130 detects charging-related signals between the EV 10 and EVSE 20. The detection unit 130 is connected to both the connection unit 120 and the control unit 110 to relay the detected values from the connection unit 120 to the control unit 110.

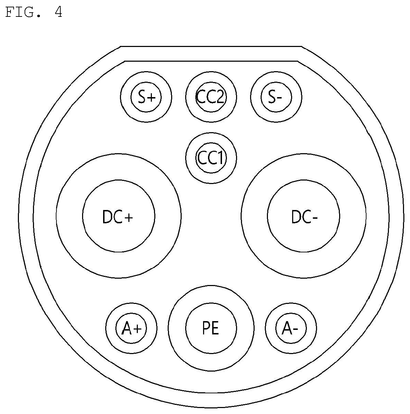

FIG. 4 is a diagram illustrating the pinout of the connector included in the EVCC according to an embodiment of the present invention. The pinout illustrated in FIG. 4 may represent the configuration seen at the end of the EV-side connector.

With reference to FIG. 4, the connection unit 120 may include a total of 9 pins. For example, the connection unit 120 may include a PE pin, a CC1 pin, a CC2 pin, a DC+ pin, a DC- pin, an A+ pin, an A- pin, an S+ pin, and an S- pin.

Here, the PE (protective earth) pin is a ground pin that may serve as a reference for the control line. The PE pin may be included in the grounding wire between the EVSE 20 and the EVCC 100. The CC1 (connection check 1) pin and CC2 (connection check 2) pin are pins for transmitting and receiving signals to detect the connection of the connector between the EVSE 20 and the EVCC 100, respectively. The CC1 pin is recognized by the EVSE 20 to verify proper connection of the connector between the EVSE 20 and the EVCC 100, while the CC2 pin may be recognized by the EVCC 100 to confirm proper connection of the connector between the EVSE 20 and the EVCC 100. CC may stand for connection check or charging confirmation. The DC- pin and DC+ pin are fast charging terminals for receiving power from the EVSE 20. The A+ and A- pins may be connected to the auxiliary battery of the EVSE 20 to enable the EVCC 100. The A+ and A- pins may be used to enable the EVCC 100 when the EV 10 is in an off state for charging. The S+ and Spins are communication lines for setting operating parameters.

Meanwhile, the end of the connector on the EVSE 20 side may have a shape corresponding to the end of the connector on the EV 10 side.

As described above, the EVCC 100 may be installed within the EV 10. Therefore, in this specification, the EV 10 side may refer to the EVCC 100.

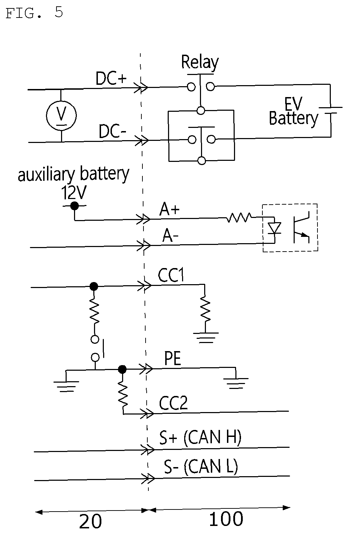

FIG. 5 illustrates a fast charging circuit between an EVSE and an EV. The fast-charging circuit between the EVSE and the EV may be represented by a circuit diagram where the end of the connector on the EV 10 side is connected to the end of the connector on the EVSE 20 side.

With reference to FIG. 5, the rated voltage for fast charging between the EVSE and the EV may range from 750V to 1000V, with rated currents of 80A, 125A, 200A, or 250A, and a maximum power of up to 250kW. The fast-charging circuit between the EVSE and the EV may be composed of three high-voltage lines and six signal lines. Here, the high-voltage lines may include the DC+ line, DC- line, and PE line, which connect the EVSE 20 and the battery of the EV 10. The signal lines may include the A+ and A-lines to enable the EVCC 100, the CC1 and CC2 lines to detect whether the connector between the EVSE 20 and EVCC 100 is properly connected, and the S+ and S- lines for data communication via CAN between the EVSE 20 and EVCC 100.

The charging process is controlled by signals transmitted between the EVSE 20 and EVCC 100 through the S+ and S- lines. The charging process may include handshake initiation and recognition, amperage and voltage configuration, charging, and suspension of charging. In the handshake stage, the S+ and S- communication lines and the A+ and A- auxiliary battery lines between the EVSE 20 and EVCC 100 are connected. The EVSE 20 sends a handshaking signal to the EVCC 100 to confirm the connection of the S+ and S- communication lines, and upon receiving a positive response from the EVCC 100, the EVSE 20 begins insulation monitoring and then sends the appropriate insulation safety message to the EVCC 100. Once the EVCC 100 verifies the insulation safety message, the EVSE 20 and EVCC 100 proceed to the charging parameter configuration stage. In this stage, the EVCC 100 sends the battery charging parameters to the EVSE 20, and the EVSE 20 responds with the maximum output capacity. After the EVCC 100 confirms this message, the EVCC 100 evaluates whether the EV 10 meets the charging conditions and then sends a message indicating that the EVCC 100 is ready. Once the readiness signal from the EVCC 100 is approved, the EVSE 20 checks its own readiness and sends a readiness signal back to the EVCC 100. After the EVCC 100 confirms the readiness signal from the EVSE 20, the charging stage begins. In this stage, the EVCC 100 sends the charging start signal and the current battery status to the EVSE 20. The EVSE 20 adjusts the output current according to the continuous feedback loop until either the EVCC 100 or the EVSE 20 sends a stop charging message.

Meanwhile, according to an embodiment of the present invention, the detection unit 130 detects a PE open between the EV 10 and the EVSE 20. Here, PE refers to the grounding wire of the high-voltage lines between the EVCC 100 and the EVSE 20, and PE open refers to the state where the grounding wire of the high-voltage lines between the EVCC 100 and the EVSE 20 is broken. In this specification, a PE open may also be referred to as a broken PE.

In an embodiment of the present invention, a fast and accurate PE open detection structure can be implemented by modifying the circuit of the charging interface between the EVSE and the EV.

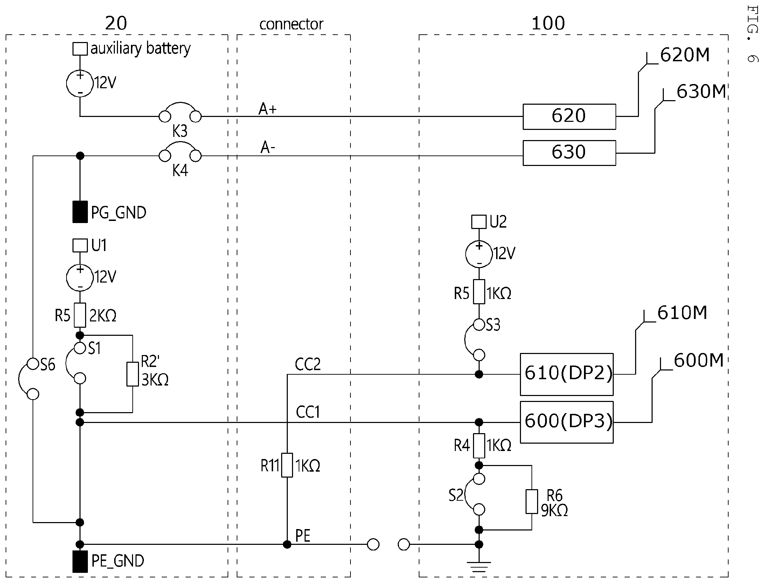

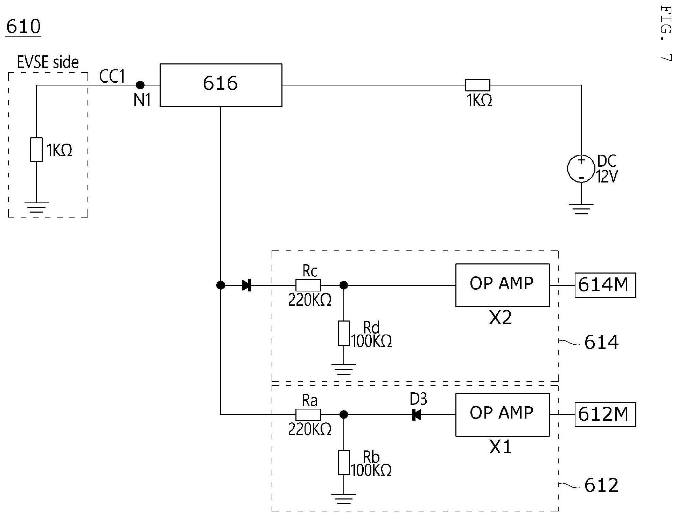

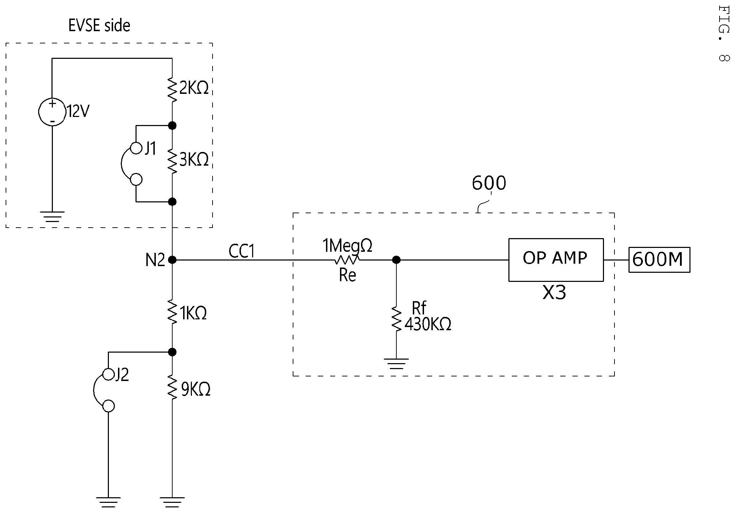

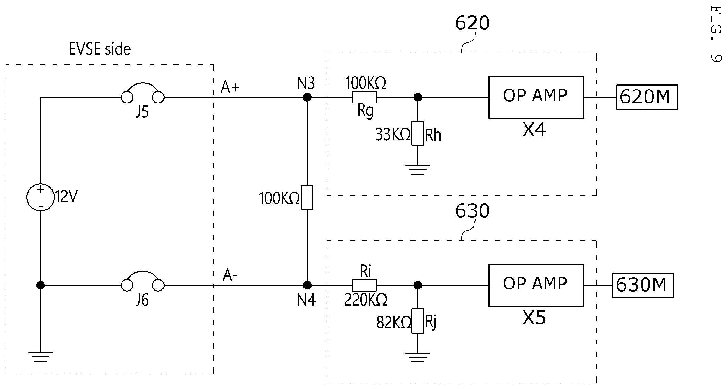

FIG. 6 is an equivalent circuit diagram of a charging interface between an EVSE and an EVCC according to an embodiment of the present invention, FIG. 7 is an equivalent circuit diagram of the CC2 line between an EVSE and an EVCC according to an embodiment of the present invention, FIG. 8 is an equivalent circuit diagram of the CC1 line between an EVSE and an EVCC according to an embodiment of the present invention, and FIG. 9 is an equivalent circuit diagram of the A+ line and A- line between an EVSE and an EVCC according to an embodiment of the present invention.

With reference to FIG. 6, the circuit for charging between the EVSE 20 and the EV 10 may be composed of three high-voltage lines and six signal lines. Here, the high-voltage lines may include the DC+ line, DC- line, and PE line, which connect the EVSE 20 and the battery of the EV 10. The signal lines may include the A+ and A- lines connected to the auxiliary battery of the EVSE 20 to enable the EVCC 100, the CC1 and CC2 lines to detect whether the connector between the EVSE 20 and EVCC 100 is properly connected, and the S+ and S- lines for data communication via CAN between the EVSE 20 and EVCC 100.

The CC1 line is the line through which a signal is transmitted for the EVSE 20 to detect whether the connector between the EVSE 20 and the EVCC 100 is properly connected, while the CC2 line is the line through which a signal is transmitted for the EVCC 100 to detect whether the connector between the EVSE 20 and the EVCC 100 is properly connected. The connection status of the EVSE 20 may be confirmed through the CC1 line, and the connection status of the EVCC 100 may be confirmed through the CC2 line. CC may stand for connection check or charging confirmation.

According to an embodiment of the present invention, the CC1 line may be connected to the EVCC 100 for wakeup. To this end, an additional pin for the CC1 signal may be added to the connector between the EVSE 20 and the EVCC 100. Although not shown, a switch for the CC1 line may also be added to the connector between the EVSE 20 and the EVCC 100.

According to an embodiment of the present invention, a switch S2 and a resistor R6 connected between the CC1 line and the PE line in the EVCC 100 may be further included. The switch S2 may be connected in series between the CC1 line and the PE line, while the resistor R6 may be connected in parallel with the switch S2.

According to an embodiment of the present invention, a switch S3 may be further arranged between the CC2 line and the power source U2 of the EVCC 100.

The switch S3 is opened before entering the charging procedure in a charging scenario. Under normal conditions, the voltage at a detection point 2 (DP2) may be detected as 0V, while the voltage at DP3 may be detected as 4V. As a result, the switches S1 and S2 are turned on, enabling charging.

Meanwhile, when the EVCC 100 determines that an emergency shutdown is necessary, a stop message corresponding to the shutdown reason may be transmitted. When an emergency shutdown is triggered during the output circuit detection phase or the subsequent phase, switch S2 is opened, whereas when the emergency shutdown is triggered before the output circuit detection phase, switch S2 is not opened. The reasons for triggering the EVCC 100 to enter an emergency shutdown state are as follows: a) when switch S1 is opened by the EVSE 20, the voltage at DP3 between the CC1 line and the control unit 110 of the EVCC 100 is 2V; b) when the vehicle connector is disconnected, the voltage at DP3 between the CC1 line and the control unit 110 of the EVCC 100 drops to 0V; and c) when a broken PE occurs during charging, with switch S3 open, the voltage at DP2 between the CC2 line and the control unit 110 of the EVCC 100 reaches -12V, while the voltage at DP3 between the CC1 line and the control unit 110 of the EVCC 100 becomes 0V.

That is, when the PE is open during charging, the voltage at DP2 changes from 0V to -12V, and the voltage at DP3 changes from 4V to 0V.

According to an embodiment of the present invention, the voltage changes on the CC2 and CC1 lines are detected to quickly and accurately identify a PE open.

According to an embodiment of the present invention, the detection unit 130 of the EVCC 100 includes a first voltage detection unit 600 connected to the CC1 line to detect the voltage value of the CC1 line, and a second voltage detection unit 610 connected to the CC2 line to detect the voltage value of the CC2 line. Here, the second voltage detection unit 610 may include a negative voltage monitoring circuit 612 for monitoring the negative voltage on the CC2 line and a positive voltage monitoring circuit 614 for monitoring the positive voltage on the CC2 line.

In addition, the control unit 120 of the EVCC 100 includes a CC1 MCU 600M that generates charging control signals based on the detection values from the CC1 detection unit 600, and a CC2 MCU 610M that generates charging control signals based on the detection values from the CC2 detection unit 610. The CC1 MCU 600M generates a charging control signal based on the detection value from the positive voltage monitoring circuit of the CC1 line. The CC2 MCU 610M may include the CC2 negative voltage monitoring MCU 612M that generates a charging control signal based on the detection value from the negative voltage monitoring circuit 612 of the second voltage detection unit 610, and the CC2 positive voltage monitoring MCU 614M that generates a charging control signal based on the detection value from the positive voltage monitoring circuit 614 of the second voltage detection unit 610. Although the CC1 MCU 600M, CC2 negative voltage monitoring MCU 612M, and CC2 positive voltage monitoring MCU 614M are shown as independent MCUs, the implementation is not limited to this configuration, and the CC1 MCU 600M, CC2 negative voltage monitoring MCU 612M, and CC2 positive voltage monitoring MCU 614M may also be implemented as a single integrated MCU. Although not shown, a circuit for the wake-up of the CC2 line may be further arranged on the CC2 line, and a circuit for the wake-up of the CC1 line may be further arranged on the CC1 line.

According to an embodiment of the present invention, when the voltage value of the CC1 line detected by the first voltage detection unit 600 and the voltage value of the CC2 line detected by the negative voltage monitoring circuit 612 of the second voltage detection unit 610 are within a predetermined range, it is determined that the PE between the EVSE 20 and the EVCC 100 is open. In more detail, when the voltage value of the CC1 line detected by the first voltage detection unit 600 is 0V, and the voltage value of the CC2 line detected by the negative voltage monitoring circuit 612 of the second voltage detection unit 610 is -12V, it is determined that the PE between the EVSE 20 and the EVCC 100 is open. Here, the voltage values of the CC1 line and CC2 line may include a predetermined margin of error. For example, when the voltage value of the CC1 line detected by the first voltage detection unit 600 is approximately 0V, and the voltage value of the CC2 line detected by the negative voltage monitoring circuit 612 of the second voltage detection unit 610 is approximately -12V, it may be determined that the PE between the EVSE 20 and the EVCC 100 is open. For example, when the voltage value of the CC1 line detected by the first voltage detection unit 600 is between 0V and 0.5V, and the voltage value of the CC2 line detected by the negative voltage monitoring circuit 612 of the second voltage detection unit 610 is between -11.5V and - 12.5V, it may be determined that the protective earth (PE) between the EVSE 20 and the EVCC 100 is open.

To achieve this, according to an embodiment of the present invention, the second voltage detection unit 610 includes a negative voltage monitoring circuit 612, a positive voltage monitoring circuit 614, and a dual FET 616 connected to the CC2 line. Here, the dual FET 616 may include two FETs connected in a back-to-back configuration. Accordingly, in this specification, the dual FET 616 may also be referred to as a back-to-back FET. The back-to-back FET is positioned between the first node (N1) of the CC2 line and DC 12V. The back-to-back FET consists of two FETs connected in series, with their body diodes oriented in opposite directions, thus preventing bidirectional current flow. When the back-to-back FET is positioned between the first node (N1) of the CC2 line and DC 12V, current flow through the CC2 line toward the EVCC 100 from the EVSE 20 is allowed, but current flow from the EVCC 100 toward the EVSE 20 through the CC2 line is blocked.

According to an embodiment of the present invention, the negative voltage monitoring circuit 612 is connected to the first node N1 of the CC2 line. The negative voltage monitoring circuit 612 may include a voltage divider resistor section and an operational amplifier (OP Amp) X1. Here, the voltage divider resistor section is positioned between the first node N1 of the CC2 line and the OP Amp X1 to divide the voltage applied to the OP Amp X1. For example, the voltage divider resistor section may include a first resistor Ra and a second resistor Rb, where one end of the first resistor Ra may be connected to the first node N1 of the CC2 line, and the other end of the first resistor Ra may be connected to one end of the second resistor Rb and the OP Amp X1. In this case, the first resistor Ra may have a value of 100kΩ or more, preferably 100kΩ or more and 1000kΩ or less, and more preferably 100kΩ or more and 500kΩ or less. Here, the first resistor Ra may be at least twice the value of the second resistor Rb. As such, when the first resistor Ra of the voltage divider section is designed to be 100kΩ or more, a structure can be achieved that accurately detects the voltage value without applying a load to the MCU, while minimizing current flow through the CC1 line in the event of a PE open, thus preventing electrical interference with the surrounding circuit.

According to an embodiment of the present invention, the negative voltage monitoring circuit 612 may further include a diode D3 positioned between the voltage divider resistor section and the OP Amp X1. The cathode of the diode D3 may be connected to the voltage divider resistor section, while the anode may be connected to the OP Amp X1. This configuration can prevent current flow from the OP Amp X1 to the voltage divider resistor section, facilitating the monitoring of negative voltages on the CC2 line.

Meanwhile, the CC2 negative voltage monitoring MCU 612M is connected to the negative voltage monitoring circuit 612, and when the voltage value detected by the negative voltage monitoring circuit 612 falls within a predetermined range, determines a PE open between the EVSE 20 and EVCC 100. For example, upon detecting -12V, the CC2 negative voltage monitoring MCU 612M may determine that the PE is open.

To facilitate this determination, the CC2 negative voltage monitoring MCU 612M may store a voltage matching table in advance to estimate the negative voltage using the voltage value detected by the negative voltage monitoring circuit 612.

Meanwhile, according to an embodiment of the present invention, the positive voltage monitoring circuit 614 may also include a voltage divider resistor section and an OP Amp X2. Here, the voltage divider resistor section is positioned between the first node N1 of the CC2 line and the OP Amp X2 to divide the voltage applied to the OP Amp X2. For example, the voltage divider resistor section may include a first resistor Rc and a second resistor Rd, where one end of the first resistor Rh may be connected to the first node N1 of the CC2 line, and the other end of the first resistor Rc may be connected to one end of the second resistor Rd and the OP Amp X2. In this configuration, the first resistor Rc may have a resistance of 100kΩ or more, preferably between 100kΩ and 1000kΩ, and more preferably between 100kΩ and 500kΩ. According to an embodiment of the present invention, when the positive voltage monitoring circuit 614 includes a voltage divider resistor section, the control unit 120 can detect high voltage values of 12V or more and 16V or less applied to the input line. Additionally, when the voltage divider resistor section of the positive voltage monitoring circuit 614 includes a high first resistor Rc of 100kΩ or more, the current flow is minimized during a PE open, thereby reducing the electrical impact on the CC2 line and improving the accuracy of negative voltage detection on the CC2 line. The voltage value detected by the positive voltage monitoring circuit 614 may be used to monitor the connection state of the EVCC 100 and the charging status.

As described with reference to FIGS. 6 to 8, the first node N1 of the CC2 line may be connected to the negative voltage monitoring circuit 612, the positive voltage monitoring circuit 614, and the dual FET 616. Accordingly, in a normal state, a signal for detecting the connector connection may be transmitted from the EVSE 20 to the EVCC 100 through the dual FET 616, and the positive voltage monitoring circuit 614 may detect the connector connection signal. Furthermore, during charging, when switch S3 is opened and PE is open, the negative voltage across the CC2 line may be detected by the negative voltage monitoring circuit 612.

According to an embodiment of the present invention, the CC1 detection unit 600 detects the voltage value of the CC1 line. The CC1 MCU 600M may estimate the voltage value of the CC1 line based on the results from the CC1 detection unit 600, and the connection state of the EVSE 20 and the charging status may be monitored based on the voltage value of the CC1 line. When the voltage value of the CC1 line is within a predetermined range, it is determined that the PE between the EVSE 20 and EVCC 100 is open. For example, when the CC1 MCU 600M detects 0V, it may be determined that the PE is open.

For this purpose, the CC1 detection unit 600 may include a voltage divider resistor section and an OP Amp X3. The voltage divider resistor section is positioned between the second node N2 of the CC1 line and the OP Amp X3, allowing it to divide the voltage entering the OP Amp X3. For example, the voltage divider resistor section may include a first resistor Re and a second resistor Rf, where one end of the first resistor Re may be connected to the second node N2 of the CC1 line, and the other end of the first resistor Re may be connected to one end of the second resistor Rf and the OP Amp X3. In this configuration, the first resistor Re may have a resistance of 100kΩ or more, preferably between 100kΩ and 1000kΩ, and more preferably between 100kΩ and 500kΩ.

According to an embodiment of the present invention, when the voltage divider resistor section of the CC1 detection unit 600 includes a first resistor of at least 100kΩ, the current flow through the CC1 line may be reduced when the PE is open.

According to an embodiment of the present invention, the EVCC 100 may further include an A+ detection unit 620 for detecting the voltage of the A+ line through which a signal for enabling the EVCC 100 is transmitted, and an A- detection unit 630 for detecting the voltage of the A- line through which a signal for enabling the EVCC 100 is transmitted. For example, when the value detected by the A+ detection unit 620 or the A-detection unit 630 is equal to or less than 0.5V, it may be determined that an enable signal has been transmitted. Depending on the specifications of the EVSE 20 or the EVCC 100, the EVCC 100 may be triggered by the A+ and A- lines connected to the auxiliary battery of the EVSE 20 when operating in low-power mode, entailing a need to detect the voltages of the A+ and A- lines. However, the circuits implemented to detect voltages on the A+ and A- lines may affect the detection performance of the first voltage detection unit 600 for the CC1 line and the second voltage detection unit 610 for the CC2 line. Accordingly, the A+ detection unit 620 and the A- detection unit 630 should be designed so as not to impact the performance of the first voltage detection unit 600 and the second voltage detection unit 610.

For this purpose, the A+ detection unit 620 may include a voltage divider resistor section and an OP Amp X4 as shown in FIG. 9. The voltage divider resistor section is positioned between the second node N3 of the A+ line and the OP Amp X4, allowing it to divide the voltage entering the OP Amp X4. For example, the voltage divider resistor section may include a first resistor Rg and a second resistor Rh, where one end of the first resistor Rg may be connected to the second node N3 of the A+ line, and the other end of the first resistor Rg may be connected to one end of the second resistor Rh and the OP Amp X4. In this configuration, the first resistor Rg may have a resistance of 100kΩ or more, preferably between 100kΩ and 1000kΩ, and more preferably between 100kΩ and 500kΩ. According to an embodiment of the present invention, when the voltage divider resistor section of the A+ detection unit 620 includes a high first resistor of 100kΩ or more, the current flow through the A+ line may be reduced in the case of a PE open, thereby minimizing the impact on the performance of the first voltage detection unit 600 and the second voltage detection unit 610.

Similarly, the A- detection unit 630 may include a voltage divider resistor section and an OP Amp X5. Here, the voltage divider resistor section is placed between the fourth node N4 of the A- line and OP Amp X5, dividing the voltage entering the OP Amp X5. For example, the voltage divider resistor section may include a first resistor Ri and a second resistor Rj, where one end of the first resistor Ri may be connected to the fourth node N4 of the A- line, and the other end of the first resistor Ri may be connected to one end of the second resistor Rj and to the OP Amp X5. In this case, the first resistor Ri may have a resistance of 100kΩ or more, preferably between 100kΩ and 1000kΩ, and more preferably between 100kΩ and 500kΩ. According to an embodiment of the present invention, when the voltage divider resistor section of the A- detection unit 630 includes a high first resistor of 100kΩ or more, the current flow through the A+ line is reduced during a PE open, minimizing the impact on the performance of the first voltage detection unit 600 and the second voltage detection unit 610.

As such, according to the embodiment of the present invention, even when the A+ detection unit 620, which detects the voltage of the A+ line through which a signal to enable the EVCC 100 is transmitted, and the A- detection unit 630, which detects the voltage of the A- line through which the signal to enable the EVCC 100 is transmitted, are included, the A+ detection unit 620 and the A- detection unit 630 can minimize their impact on the PE open detection performed by the first voltage detection unit 600 and the second voltage detection unit 610.

Table 1 shows the results of a simulation of the performance of the circuits in FIGS. 6 to 9.

**[Table 1]**

| conditions | signal | EVSE side PE&PG not connected | | EVSE side PE&PG connected | |
|---|---|---|---|---|---|
| | | Only A+ connected | A+ & A-connected | Only A+ connected | A+ & A-connected |
| | | Value (V) input to EV-side MCU | | | |
| Normal state | A+ | 0 | 1.07 | 2.98 | 2.98 |
| | A- | 0 | 0 | 2.45 | 0 |
| | CC1 | 4 | 4 | 4 | 4 |
| | CC2 | 0 | 0 | 0 | 0 |
| PE open | A+ | 0 | 1.07 | 0 | 0 |
| | A- | 0 | 0 | 0 | 0 |
| | CC1 | 0 | 0 | 0 | 0 |
| | CC2 | -11.78 | -11.78 | -11.78 | -11.64 |

With reference to Table 1, when a PE open occurs after entering charging mode and opening switch S3, the voltage of the CC1 line changes from 4V to 0V, and the voltage of the CC2 line changes from 0V to approximately -12V, indicating that the PE open can be detected by using the voltage changes in both the CC1 and CC2 lines.

Specifically, with reference to FIGS. 6 to 9 and Table 1, when a PE open occurs while the A+ and A- lines are not connected to the EVCC 100 side, i.e., when the EVCC 100 side is not using the A+ and A- lines, no current flow is formed from the EVSE 20 side power source U1 to the PE line through the CC1 line, indicating that the PE open can be detected by the voltage changes in both the CC1 and CC2 lines.

Furthermore, with reference to FIGS. 6 to 9 and Table 1, even when the A+ and A- lines are connected to the EVCC 100 side, as long as the grounds of the auxiliary battery side (PG) and the power source U1 side (PE) of the EVSE 20 are different, no current flow is formed from the EVSE 20 side power source U1 to the PE line through the CC1 line, indicating that the PE open can be detected by the voltage changes in both the CC1 and CC2 lines.

Also, with reference to FIGS. 6 to 9 and Table 1, when the A+ and A- lines are connected to the EVCC 100 side, and the ground of the auxiliary battery side (PG) of the EVSE 20 is connected to the ground of the power source U1 side (PE), current flow can be formed from the EVSE 20 side power source U1 through the CC1 line, A+ line, and A- line. By designing the first resistors in the A+ detection unit 620 and A- detection unit 630 to be 100kΩ or more, as in the embodiment of the present invention, the current flow is controlled during a PE open, minimizing the impact of the A+ detection unit 620 and A- detection unit 630 on the performance of the first voltage detection unit 600 and second voltage detection unit 610, thereby enabling precise detection of voltage changes in both the CC1 line and CC2 line.

Although the preferred embodiments of this invention have been described above, it will be understood by those skilled in the art that this invention can be variously modified and changed without departing from the spirit and scope of this invention as set forth in the following patent claims.

### [DESCRIPTION OF REFERENCE NUMERALS]

- 10:: EV
- 20:: EVSE
- 22:: charging cable
- 100:: EVCC
- 110:: control unit
- 120:: connection unit
- 130:: detection unit

## Claims

1. An electric vehicle charging controller (EVCC) comprising:
a connection check 1 (CC1) line configured to transmit a signal to detect a connector connection between an electric vehicle supply equipment (EVSE) and the electric vehicle charging controller;
a connection check 2 (CC2) line configured to transmit a signal to detect the connector connection between the EVSE and the electric vehicle charging controller;
a first voltage detection unit connected to the CC1 line to detect the voltage of the CC1 line;
a second voltage detection unit connected to the CC2 line to detect the voltage of the CC2 line; and
a control unit configured to determine whether a protective earth (PE) between the EVSE and the electric vehicle charging controller is open based on the detected values by the first and second voltage detection units being within a predetermined range,
wherein the second voltage detection unit comprises a back-to-back field effect transistor (FET) connected to the CC2 line, a positive voltage monitoring circuit, and a negative voltage monitoring circuit.

2. The electric vehicle charging controller of claim 1, wherein the negative voltage monitoring circuit comprises a voltage divider resistor section and an operational amplifier (OP Amp).

3. The electric vehicle charging controller of claim 2, wherein the voltage divider resistor section comprises a first resistor and a second resistor, one end of the first resistor being connected to the CC2 line, and the other end of the first resistor being connected to one end of the second resistor and the OP Amp.

4. The electric vehicle charging controller of claim 3, wherein the first resistor is 100kΩ or more.

5. The electric vehicle charging controller of claim 1, wherein the positive voltage monitoring circuit comprises a voltage divider resistor section and an operational amplifier (OP Amp).

6. The electric vehicle charging controller of claim 1, wherein the CC1 line is configured to transmit a signal for detecting the connector connection on the EVSE side, and the CC2 line is configured to transmit a signal for detecting the connector connection on the electric vehicle charging controller side.

7. The electric vehicle charging controller of claim 6, wherein the first voltage detection unit comprises a voltage divider resistor section and an operational amplifier (OP Amp).

8. The electric vehicle charging controller of claim 1, wherein the control unit estimates the negative voltage of the voltage value detected by the negative voltage monitoring circuit using a pre-stored voltage matching table.

9. The electric vehicle charging controller of claim 1, further comprising:
an A+ line configured to transmit a signal to enable the electric vehicle charging controller;
an A- line configured to transmit a signal to enable the electric vehicle charging controller;
an A+ detection unit configured to detect the voltage of the A+ line; and
an A- detection unit configured to detect the voltage of the A- line.

10. The electric vehicle charging controller of claim 9, wherein the A+ detection unit and the A- detection unit each comprise a voltage divider resistor section and an operational amplifier (OP Amp).
